# EUROPEAN PATENT APPLICATION

(11) **EP 1 429 393 A2**
(43) Date of publication of application: **16.06.2004**
(21) Application number: 03028437.6
(22) Date of filing: 11.12.2003
(51) Int. Cl.: H01L 31/00

(54) **Solar cell module**

(30) Priority: 13.12.2002 JP 2002361986; 09.05.2003 JP 2003131148
(71) Applicant: CANON KABUSHIKI KAISHA, Ohta-ku, Tokyo (JP)
(72) Inventor: Toyomura, Fumitaka, Ohta-ku, Tokyo (JP)
(74) Representative: Leson, Thomas Johannes Alois, Dipl.-Ing.

(57) **Abstract**

A solar cell module (101) is provided with at least one power conversion unit (106) having a plurality of solar cell elements (102) and a power converter (103) provided in a position corresponding to a region surrounded by all the solar cell elements. Because the wiring distance from the output terminal of each solar cell element up to the input terminal of the power converter can be shortened, it is possible to reduce the loss of a wiring through which a low-voltage large current flows and provide an inexpensive solar cell module having a less collecting loss between the solar cell element and the power converter.

## Description

### BACKGROUND OF THE INVENTION

### Field of the Invention

The present invention relates to a solar cell module having a plurality of solar cell elements and a power converter or a solar cell module having a plurality of solar cell elements and a terminal box. Related Background Art

In recent years, many solar power generation systems are set each of which converts DC power generated by a solar cell into AC power by a power converter and supplies the AC power to a domestic load and/or a commercial power system (hereinafter referred to as "system").

Moreover, a solar cell module in which a small-size power converter (hereinafter referred to as "power converter") referred to as MIC (Module Integrated Converter) for converting the power generated by a solar cell is set to a surface (hereinafter referred to as "back" or "non-light-receiving surface") of a solar cell on a side opposite to the light-receiving surface of the solar cell is expected as a small- or medium-scale solar power generation system or emergency power source.

Above all, development of a solar cell module (such as AC module) in which a power converter for converting the DC power generated by a solar cell into AC power or voltage-converting DC power is integrally provided with the enclosure of a solar cell is noticed.

The above solar cell module inputs an output power from a solar cell module composed of a plurality of solar cell elements connected in series to a power converter mounted on the non-light-receiving surface of the solar cell module and the power converter outputs the output power as AC power. A solar cell module is disclosed in Japanese Patent Application Laid-Open No. H9-271179 as an example.

However, the above-described prior art has the following problem.

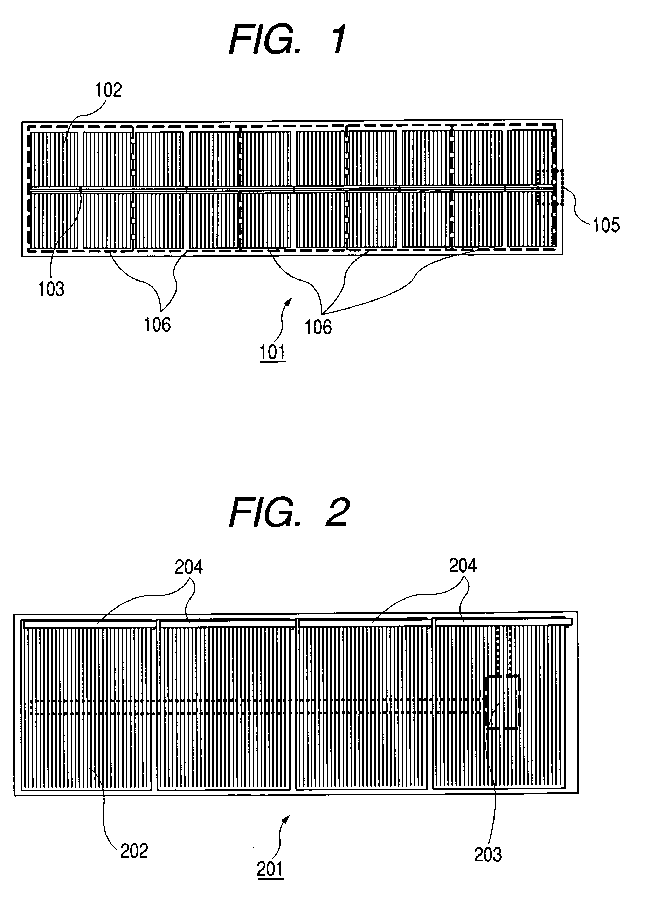

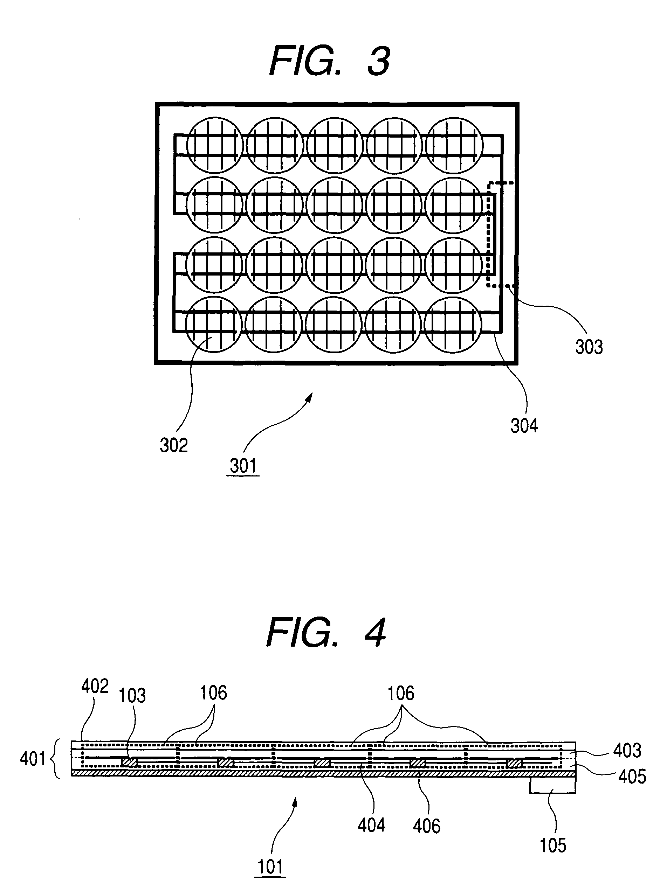

As a typical example, FIGS. 2 and 3 respectively show a solar cell module integrated with a power converter.

In this case, for example, a plurality of solar cell elements 202 and 302 are connected in series by connection members (204: connection member, 304:
connection member) in a solar cell module and power is collected in power converters 203 and 303, the DC power generated by solar cells is converted into AC power and the AC power is output.

According to the above configuration, because many solar cell elements are sequentially connected in series, members for series connection are necessary by almost the number of solar cell elements. Moreover, it is necessary to extend a collecting member up to a power converter and use a complex connection step.

Therefore, in order to minimize the number of solar cells to be connected in series, it is considered to increase a solar cell element in area and power generation capacity.

Ultimately, as described in Markus Wuest, Peter Toggweiler, Jon Riatsch: SINGLE CELL CONVERTER SYSTEM (SCCS), First WCPEC, Hawaii, Dec 5-9, p. 813-815, 1994, a method for connecting one power converter to one solar cell element to take out an output is proposed.

In the case of the above configuration, however, a problem occurs that a collecting loss from each portion of a solar cell element up to a power converter is increased as an output current is increased due to increase of a solar cell element in area.

The above problem becomes more remarkable as the area of a solar cell element increases and an output current increases.

Moreover, it is considered that the above power converter controls itself by using the output power of a solar cell element.

In this case, the optimum operating voltage of one general solar cell element ranges from 0.7 to 1.4 V. However, a voltage of 3.3 or 5 V is usually necessary in order to operate devices in the control circuit of a power converter.

In the case of the above method such as SCCS, it is considered to boost the optimum operating voltage of a solar cell element to 3.3 or 5 V by using a power IC. In the case of the above boosting from a low voltage, however, a conversion efficiency is greatly lowered to 50 to 70% when using a simple circuit and this causes the whole system efficiency to lower.

Moreover, a complex circuit is necessary to improve the conversion efficiency and therefore, a problem occurs that the system cost is increased or a power converter is increased in size.

Therefore, in order to solve the above problems, it is effective to connect a plurality of solar cell elements in series and make boosting of a voltage for generation of a power-converter control voltage unnecessary.

### SUMMARY OF THE INVENTION

The present invention has been made to solve the problems of the above-described prior art and its object is to provide an inexpensive solar cell module having a less collecting loss from a solar cell element to a power converter.

Moreover, it is an object of the present invention to provide a solar cell module having a converter with a less control power source generation loss.

A first invention for solving the above problems is a solar cell module provided with at least one power conversion unit having a plurality of solar cell elements and a power converter provided in a position corresponding to a region surrounded by all the solar cell elements.

In the first invention, the present invention includes the following as its preferable mode:
"at least two of the power conversion units are included and each power converter is electrically connected to a power converter of an adjacent power conversion unit",
"outputs of the solar cell elements are inputted to power converters respectively corresponding to the solar cell elements and the power converters convert the inputted outputs of the solar cell elements and output the converted outputs",
"all output terminals of the solar cell elements are electrically connected to all input terminals of the power converters corresponding to the output terminals, respectively",
"the input terminals of the power converters are provided on the same and one surface" and
"photovoltaic layers of the solar cell elements have pn junctions or pin junctions of two or more layers".

A second invention for solving the above problems is a solar cell module provided with at least one power conversion unit having a plurality of solar cell elements arranged on a plane and a power converter, in which the power converter is provided in a position of minimizing the sum of all collecting losses when collecting the power generated by the solar cell elements to the power converter.

A third invention for solving the above problems is a solar cell module provided with at least one power conversion unit having a plurality of solar cell elements arranged on a plane and a power converter, in which the solar cell elements have terminal members and the power converter is arranged in the closest position between the terminal members in a state of arranging the solar cell elements.

A fourth invention for solving the above problems is a solar cell module provided with at least one power conversion unit having a plurality of solar cell elements arranged on a plane and a power converter, in which the solar cell elements have terminal members and the power converter is arranged in the closest position between the terminal members in a state of arranging the solar cell elements and in a position of minimizing the sum of all collecting losses when collecting the power generated by to the power converter.

A fifth invention for solving the above problems is a solar cell module provided with at least one power conversion unit having two adjacent solar cell elements and a power converter provided in a position corresponding to a region on the extension of a gap between the two adjacent solar cell elements.

In the fifth invention, the present invention includes the following as its preferable mode:
"at least two of the power conversion units are included and each power converter is electrically connected to a power converter of an adjacent power conversion unit" and
"outputs of the two adjacent solar cell elements are input to the power converter corresponding to the solar cell elements and the power converter converts the inputted outputs of the two adjacent solar cell elements and outputs the converted outputs.

A sixth invention for solving the above problems is a solar cell module provided with at least one power generation unit having a plurality of solar cell elements and a terminal box provided in a position corresponding to a region surrounded by all the solar cell elements to collect outputs of the solar cell elements.

In the sixth invention, the present invention includes the following as its preferable mode:
"at least two of the power generation unit are included and each power generation unit is electrically connected to the terminal box of an adjacent power generation unit."

A seventh invention for solving the above problems is a solar cell module provided with at least one power generation unit having two adjacent solar cell elements and a terminal box provided in a position corresponding to a region on the extension of a gap between the two adjacent solar cell elements to collect outputs of the two adjacent solar cell elements.

In the seventh invention, the present invention includes the following as its preferable mode:
"at least two of the power generation unit are included and each power generation unit is electrically connected to the terminal box of an adjacent power generation unit".

As described above, according to the present invention, it is possible to provide a solar cell module having a less power loss.

Other features and advantages of the present invention will be apparent from the following description taken in conjunction with the accompanying drawings.

### BRIEF DESCRIPTION OF THE DRAWINGS

FIG. 1 is a schematic view showing an example of a solar cell module of the present invention;
FIG. 2 is a schematic view showing an example of a conventional solar cell module;
FIG. 3 is a schematic view showing an example of a conventional solar cell module;
FIG. 4 is a schematic sectional view of an example of a solar cell module used for the present invention;
FIG. 5 is a schematic sectional view of an example of a solar cell element used for the present invention;
FIG. 6 is a schematic view of an example of a solar cell element used for the present invention;
FIG. 7 is a schematic view of an example of an input terminal pattern of a power converter used for the present invention;
FIG. 8 is a schematic view of an example of an input terminal pattern of a power converter used for the present invention;
FIG. 9 is a schematic view of an example of a power converter used for the present invention;
FIG. 10 is a schematic view of an example of an input terminal portion of a power converter used for the present invention;
FIG. 11 is a schematic view of an example of a power conversion unit used for the present invention;
FIG. 12 is a schematic view of an example of a terminal portion of a solar cell element used for the present invention;
FIG. 13 is a layout diagram of an example of a solar cell element of a power conversion unit used for the present invention;
FIG. 14 is a schematic view showing an example of a solar cell module of the present invention;
FIG. 15 is a schematic view showing an example of a solar cell module of the present invention;
FIG. 16 is a schematic view showing an example of a solar cell element used for the present invention;
FIG. 17 is a schematic view showing an example of a solar cell module of the present invention;
FIG. 18 is a schematic sectional view of an example of a solar cell module of the present invention;
FIG. 19 is a layout diagram showing an example of a layout of solar cell elements of a power conversion unit used for the present invention;
FIG. 20 is a schematic view of an example of an input terminal portion of a power converter used for the present invention;
FIG. 21 is a schematic view of an example of a power conversion unit of the present invention;
FIG. 22 is a layout diagram showing an example of a layout of solar cell elements of a power conversion unit used for the present invention;
FIG. 23 is a schematic view of an example of an input terminal portion of a power converter used for the present invention;
FIG. 24 is a schematic view of an example of a power conversion unit of the present invention;
FIG. 25 is a schematic view of an example of a power converter used for the present invention;
FIG. 26 is a schematic view of an example of a solar cell module of the present invention;
FIG. 27 is a schematic view of an example of a solar cell element used for the present invention;
FIG. 28 is a layout diagram showing an example of a layout of solar cell element used for the present invention; and
FIG. 29 is a schematic sectional view of an example of a solar cell module of the present invention.

### DESCRIPTION OF THE PREFERRED EMBODIMENTS

Embodiments of the present invention are described below by referring to the accompanying drawings. However, the present invention is not restricted to the embodiments.

For example, a solar cell element, power converter, and solar cell module of the present invention are described below. However, the scope of the present invention is not restricted to the following described cases.

The outline of a solar cell module 101 is first described, then a solar cell element 102 and a power converter 103 are described and finally a method for fabricating a power conversion unit or a solar cell module using the solar cell element 102 and power converter 103 is described.

FIG. 1 is a schematic view showing a configuration example of the solar cell module 101 of an embodiment of the present invention.

Moreover, FIG. 4 is a schematic sectional view of the solar cell module 101.

Furthermore, a configuration of the solar cell module 101 is described below by using FIGS. 1 and 4.

In this case, a solar cell module body 401 is constituted by a weather resistant film 402, a filler 403, a plurality of power conversion units 106, a filler 405 and a back reinforcement 406.

The weather resistant film 402 is set to the light-receiving surface of the body 401 and a plurality of power conversion units 106 are set in the body 401.

Transparent fillers 403 and 405 are arranged around the power conversion units 106 to fix the power conversion units 106.

Moreover, a back reinforcement 406 for reinforcement is set to the back at the opposite side to the light-receiving surface of the solar cell module body 401.

Furthermore, each power conversion unit 106 is constituted by a plurality of solar cell elements 102 and a power converter 103 surrounded by all solar cell elements in the power conversion unit as shown in FIG. 1. Thus, in the case of the present invention, a position corresponding to a region surrounded by all solar cell elements in a power conversion unit denotes the center of a layout of solar cell elements when constituting a power conversion unit by three or more solar cell elements (the configuration in FIG. 1 is applied to this case). In the case of a power conversion unit in which two solar cell elements are arranged like the case of Example 2 to be described later, the position denotes the portion between the solar cell elements.

Furthermore, power converters 103 adjacent to each other are connected by a lead wire 404, the collected electricity is connected to another power converter 105 and taken out to the outside by a solar cell module.

### (Solar cell element)

First, a configuration of each solar cell element 102 is specifically described below.

It is allowed to use a solar cell element as long as the element has at least a photovoltaic device for generating power, and a positive-electrode terminal and a negative-electrode terminal for outputting a power from the device.

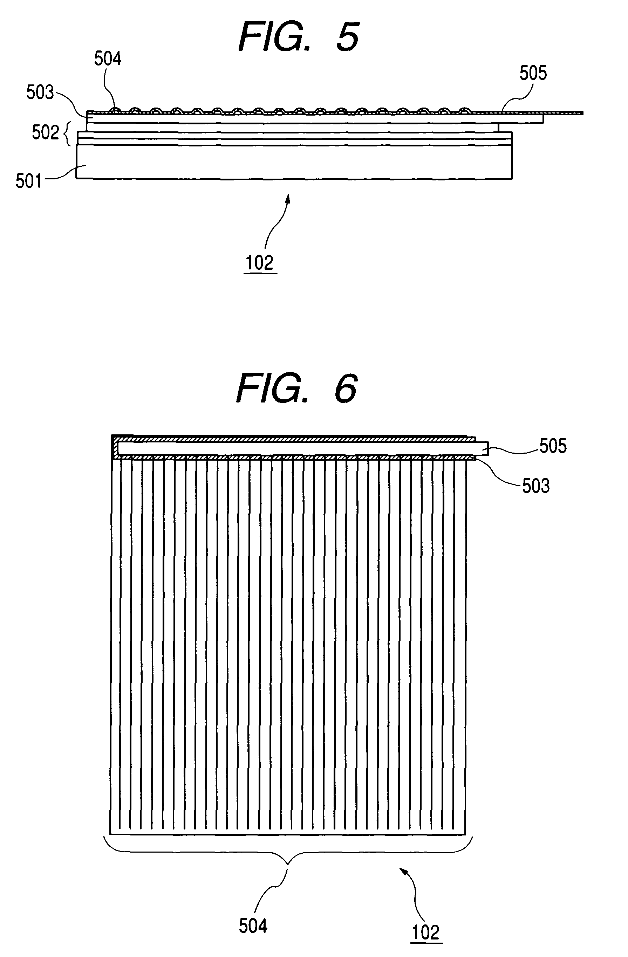

In this case, thin-film silicon preferably used to increase a solar cell element in area, particularly the case of amorphous silicon is described in detail by referring to FIGS. 5 and 6.

For example, as shown in FIG. 5, a solar cell element is used which has a photovoltaic layer 502 formed by stacking a lower electrode layer, a semiconductor layer and an upper electrode layer in mentioned order on a conductive substrate 501. It is allowed to omit the lower electrode layer depending on a configuration of the conductive substrate.

The lower electrode layer, semiconductor layer and upper electrode layer used for the above case are disclosed in detail in Japanese Patent Application Laid-Open No. H11-186572. Detailed description of these components is omitted because they are not essential in the present invention.

When using amorphous silicon for a semiconductor layer, a pin junction is usually used which is formed by stacking an n-type semiconductor, i-type semiconductor and p-type semiconductor in mentioned order from the conductive substrate side.

Moreover, a solar cell element having a comparatively-high maximum power voltage is also preferably used which is formed into a double or triple configuration by stacking the above pin junction or pn junction up to two or three layers.

Furthermore, it is possible to properly select as a method for forming each layer from publicly known and publicly used methods such as vapor deposition method, sputtering method, high-frequency plasma CVD method, microplasma CVD method, ECR method, thermal CVD method, LPCVD method and the like.

Furthermore, because the conductive substrate 501 serves as a member for mechanically supporting the photovoltaic layer 502, it is also possible to use the substrate 501 as a common electrode of non-light-receiving surfaces of a plurality of solar cell elements.

Furthermore, it is preferable to use a conductive substrate having a heat resistance capable of withstanding a heating temperature when forming a semiconductor layer.

It is possible to use one of the following materials as the material of a conductive substrate: metals such as Fe, Ni, Cr, Al, Mo, Au, Nb, Ta, V, Ti, Pt and Pb, alloys of these metals such as thin plate of brass or stainless steel and complex of brass and stainless steel, carbon sheet and galvanized steel plate.

Moreover, it is allowed to use as a base material for the substrate an electrically insulating material or film or sheet of heat-resistant synthetic resin such as one of polyester, polyethylene, polycarbonate, cellulose acetate, polypropylene, polyvinyl chloride, polyvinylidene chloride, polystyrene, polyamide and epoxy. A composite of one of the above synthetic resins and one of glass fiber, carbon fiber, boron fiber and metal fiber, and a composite of one of these thin plate and resin sheets having a metallic thin film obtained by vapor-depositing or stacking a different material on the surface thereof is used as the substrate.

Then, by dividing the photovoltaic layer thus formed into a plurality of layers, applying an etching paste containing FeCl₃ and AlCl₃ onto the upper electrode layer through the screen printing method so that an effective light-receiving range is not influenced by a short circuit between the conductive substrate and the upper electrode layer generated when dividing the photovoltaic layer, heating and then cleaning the electrode, it is possible to linearly remove a part of the upper electrode layer, form an etching line and obtain a photovoltaic device having a desired size.

Moreover, an insulating double-side adhesive tape 503 is attached to one side of the light-receiving surface of the conductive substrate to form a collecting electrode 504 on the insulating double-side adhesive tape and the upper electrode at a predetermined interval.

Furthermore, a light-receiving-surface terminal member 505 is attached onto the insulating double-side adhesive tape 503 though thermal contact bonding.

According to the above steps, the solar cell element 102 on which the collecting electrode 504 and light-receiving-surface terminal member 505 shown in FIGS. 5 and 6 are set is constructed.

In this case, a non-light-receiving-surface terminal member may be provided on the side of the non-light-receiving surface of the conductive electrode 501 according to necessity.

Moreover, when using a non-light-receiving terminal member, it is also possible to improve the collecting efficiency by setting a non-light-receiving-surface terminal member on the whole non-light-receiving surface in a pectinate or radial pattern.

The light-receiving-surface terminal member used above is a member for forming a positive or negative electrode of a solar cell element by electrically connecting with the above collecting electrode.

The terminal member is mechanically firmly set to an etched surface from which the conductive substrate or the upper electrode layer of the photovoltaic device is removed by laser welding, conductive adhesive or brazing so that the terminal member electrically has a low resistance. Or, the terminal member is set on a collecting electrode by pressing.

It is preferable that the terminal member has a foil shape capable of keeping the flatness of a solar cell element and decreasing the resistance of the terminal member.

Moreover, it is allowed to stack a transparent thin resin layer on the light-receiving surface of the solar cell element 102. Detailed description of components of the transparent thin resin layer is omitted because the components are not essential in the present invention.

In the case of this embodiment, a structure is used in which a solar cell element is protected from an outdoor environment by sealing a solar cell element with a weather-resistant film, filler and back reinforcement and thereby fabricating a solar cell module. However, it is also possible to set a solar cell element outdoors by using only a transparent thin resin layer depending on the setting style.

Moreover, though an amorphous silicon solar cell is described above in detail, a solar cell is not restricted to the amorphous silicon solar cell. For example, it is also possible to use a silicon-semiconductor single-crystal-silicon solar cell, polycrystal-silicon solar cell, compound semiconductor solar cells such as III-V-group compound solar cell, II-VI-group compound solar cell and I-III-VI-group solar cell.

### (Power converter)

Then, a power converter of the present invention is described below.

First, a case is described in which the power converter of this embodiment is a DC-DC converter.

In general, a DC-DC converter connected to a solar cell element is constituted by a boosting circuit for boosting an output DC voltage of a solar cell element, a control circuit for controlling start/stop of power conversion, optimization of the operating point of a solar cell and operating mode, a system-connected protection circuit, a communication circuit and input/output terminals, an output of the DC-DC converter is directly connected to a load or outputs of a plurality of DC-DC converters are inputted to one inverter and converted AC power is used as a load or system-connected.

It is possible to use one of various circuit publicly-known and publicly-used configurations independently of insulation or non-insulation as the boosting circuit. The control circuit is provided with, for example, a CPU, PWM waveform control circuit, maximum power point tracking circuit, control power source generation circuit, frequency and voltage reference generator and switching control circuit.

Moreover, it is allowed to set the control circuit so that it can be operated from an external unit through a communication line and it is possible to simultaneously control a plurality of power converters by setting some of functions of the control circuit out of a DC-DC converter.

In the case of a DC-DC converter of the present invention, however, it is preferable to use a configuration having at least a control power source generation circuit, a switching reference waveform generation circuit for specifying a switching frequency and a switching-device driving circuit capable of driving a switching device at a fixed duty.

Moreover, it is preferable to use a switching device to be turned on/off by the switching-device driving circuit and a switching transformer formed at a predetermined turn ratio.

In the case of a system in which the DC-DC converters are connected in parallel, it is possible to change input voltages of the DC-DC converters by changing input voltages of an inverter connected to the output side, thereby moving the operating point of a solar cell element.

When applying the above to the solar cell module 101 of the present invention, it is possible to control input voltages of the power converters 103 respectively serving as a DC-DC converter connected to the inverter by changing input voltages of the inverter when each power converter 105 is an inverter.

Moreover, by forming a DC-DC converter into a chip and electrically connecting the chip to a surface wiring member, a back wiring member or a conductive substrate at a position corresponding to a region surrounded by all solar cell elements present in a predetermined region during a fabrication step to constitute a power conversion unit, it is possible to simplify a series of operations for connecting the DC-DC converter to the solar cell elements.

Furthermore, a case is described below in which the power converter of this embodiment is an inverter.

In general, an inverter used for a solar power generation system is constituted by a boosting circuit for booting an input DC voltage into an input voltage of an inverter circuit, an inverter circuit for converting DC power into AC power, a control circuit for controlling start/stop of power conversion, optimization of the operating point of a solar cell and operating mode, a system-connected protection circuit, a communication circuit and input/output terminals, and an output of the inverter is used as a load or system-connected.

It is possible to use one of various publicly-known publicly-used circuit systems independently of insulation or non-insulation as the boosting circuit. As the inverter circuit, it is preferable to use a voltage-type inverter which uses an IGBT or MOSFET for a switching device. By driving the gate of the switching device in accordance with a control signal of the control circuit, it is possible to obtain AC power having a desired frequency, phase and voltage.

The control circuit is provided with, for example, a CPU, PWM waveform control circuit, a frequency and voltage reference generator, a maximum power point tracking circuit, a current reference generator, a mode switch and a switching control circuit. Moreover, to connect a plurality of inverters of the present invention to a plurality of solar cell units respectively, it is allowed to set a control circuit so that it can be operated from an external unit through a communication line and it is also possible to simultaneously control a plurality of inverters by concentrically setting control circuits out of the inverters.

Furthermore, though an inverter with an insulating transformer and an inverter with no insulating transformer are present, it is allowed to use either of them in accordance with the purpose.

It is necessary that the above-described DC-DC converters and inverters have performances such as moisture resistance, water resistance, electrical insulating property, oil resistance, weather resistance, impact resistance and water proofing property depending on their use conditions.

When considering the above factors, the following plastics can be used as materials of an outer covering member for the converters and inverters: resins such as polycarbonate, polyamide, polyacetal, denaturized PPO (PPE), polyester, polyarylate, unsaturated polyester, phenol resin, epoxy resin, polybutylene terephthalate and nylon, and engineering plastic. Thermoplastic resins such as ABS resin, polypropylene, polyvinyl chroride may be used.

Moreover, when setting a power converter to the light-receiving surface side, it is preferable to use carbon black as a pigment for improving the ultraviolet resistance or apply a resin paint for absorbing ultraviolet radiation to the surface.

Furthermore, it is possible to use not only a quadrangular boxy shape but also circular or elliptic boxy shape as the shape of the outer covering member for the power converter in accordance with shapes of a plurality of solar cell elements or the circuit layout of internal circuits of a power converter.

Furthermore, it is preferable that input terminals of a power converter are set on the same face of the outer covering member of the power converter and, for example, it is constituted by one through-hole substrate. Thereby, it is possible to easily connect the terminals with a plurality of solar cell elements two-dimensionally arranged.

Furthermore, it is preferable to set input terminals of a power converter in number equal to the total number of output terminals of a plurality of solar cell elements in a power conversion unit and it is preferable that each input terminal has a structure such that the series-parallel configuration of the solar cell elements is decided by electrically connecting the power converter with the solar cell elements.

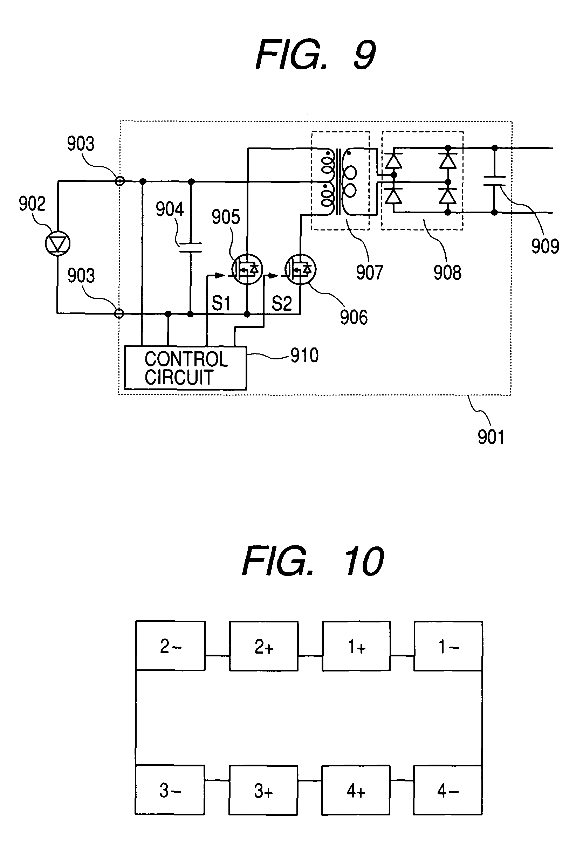

For example, it is possible that a power converter 103 corresponding to a power conversion unit 106 in FIG. 1 has a structure in which eight input terminals corresponding to four solar cell elements of 1+ and 1-, 2+ and 2-, 3+ and 3- and 4+ and 4- are set on the face directly contacting with the solar cell elements as shown in FIG. 10.

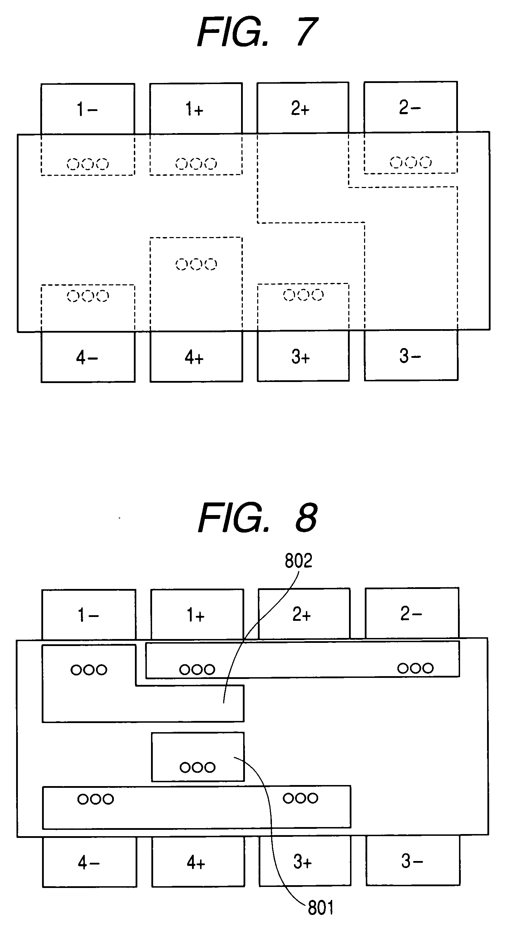

In this case, input terminals are connected each other by internal substrate patterns having via-holes (portions shown by ; in FIG. 8) so that 1+ and 2-, 2+ and 3-, and 3+ and 4- are electrically connected each other as shown in FIG. 7 or 8 in the power converter, four solar cell elements electrically are connected in series in the power converter and the output power of these solar cell elements is inputted to a power conversion circuit through a positive electrode 801 and a negative electrode 802.

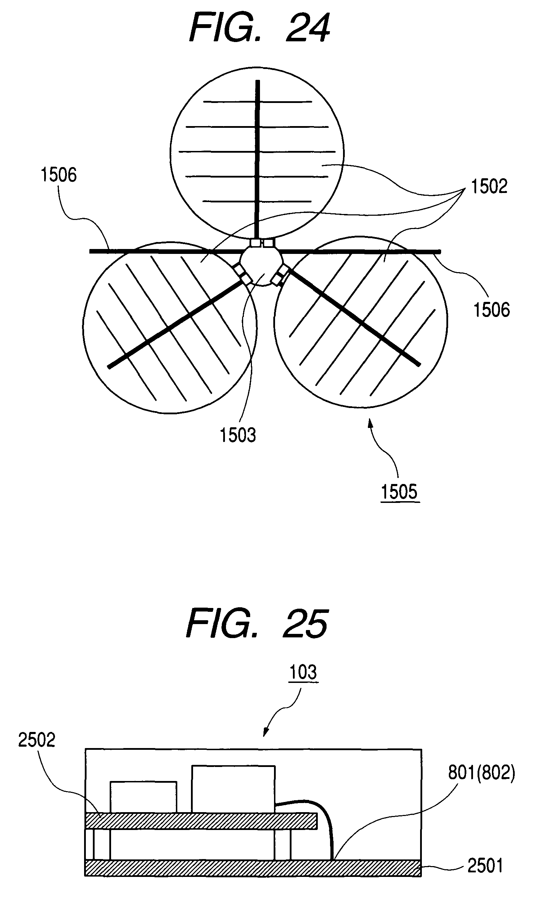

In this case, as shown in FIG. 25, a substrate 2501 provided with an input terminal and a power conversion circuit substrate 2502 opposite to a solar cell element via the substrate 2501 are previously electrically connected each other in a power converter.

In this case, FIG. 7 shows a schematic perspective view of a pattern between input terminals at the solar-cell side layer as viewed from the power-conversion-circuit substrate side, and FIG. 8 shows a schematic view of a pattern between input terminals at the power-conversion-circuit substrate side.

In this case, a substrate provided with input terminals and a power-conversion-circuit substrate are constituted by substrates different from each other. However, the input terminals and the power conversion circuit may be provided on the same and one substrate.

Moreover, in this case, all solar cell elements are connected in series in a power converter. However, it is possible to change series and/or parallel configurations in accordance with the internal configuration of a power converter according to necessity.

Furthermore, it is preferably performed to set a bypass diode in parallel with a solar cell element in a power converter according to necessity.

### (Power conversion unit)

Then, a power conversion unit of the present invention is described below.

The power conversion unit of the present invention shows a basic block unit constituted by a plurality of solar cell elements and one power converter and one or more power conversion units forms or form a solar cell module. The power converter is provided in a region surrounded by all solar cell elements constituting a power conversion unit. It is more preferable to set power converters on at least a part of all solar cell elements in the power conversion unit.

In the case of the present invention, by forming the power conversion unit thus constituted into a solar cell module, it is possible to shorten the wiring distance from the output terminal of each solar cell element up to input terminals of a power converter. Therefore, it is possible to reduce the loss of a wiring through which a low-voltage current flows and provide an inexpensive solar cell module having a less collecting loss from a solar cell element to a power converter. That is, outputs of a plurality of solar cell elements constituting a power conversion unit are inputted to power converters included in the power conversion unit.

Moreover, by connecting a plurality of solar cell elements in series in a power conversion unit like the case of this embodiment, it is possible to obtain a voltage of 3.3 V or 5 V usually used to operate devices in the control circuit of a power converter while normally operating each solar cell element at an optimum operating voltage of 0.7 to 1.4 V, and an advantage of reducing the control power source generation loss of a power converter is obtained in addition to the above advantage.

### (Fabrication method)

### (Fabrication of power conversion unit)

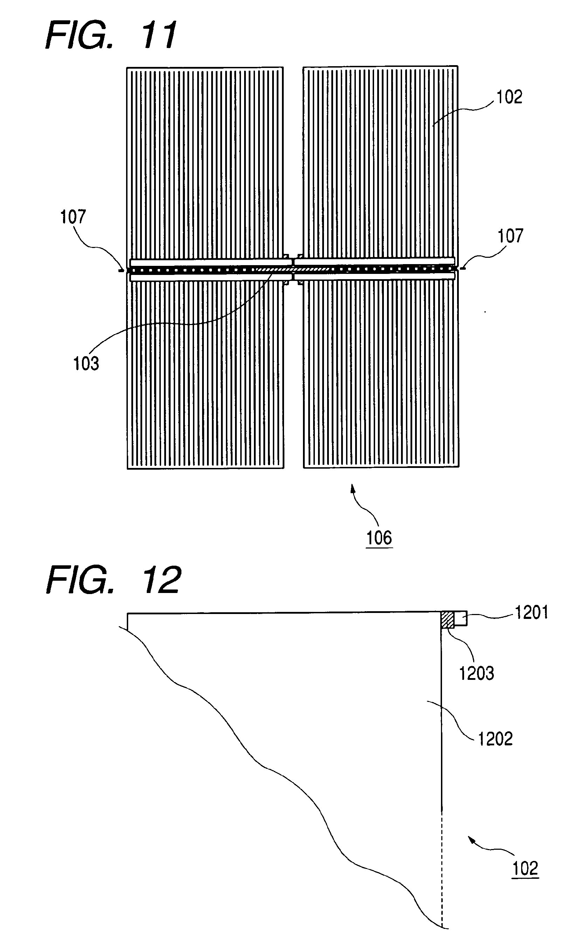

Then, a method for fabricating the power conversion unit 106 is described below by referring to FIGS. 11, 12 and 13.

First, as shown in an enlarged view of a terminal portion viewed from the non-light-receiving surface side in FIG. 12, a light-receiving-surface terminal member 1201 is extended through an insulating double-side adhesive tape 1203 so that the light-receiving-surface terminal member 1201 and a conductive substrate 1202 form an almost flat plane.

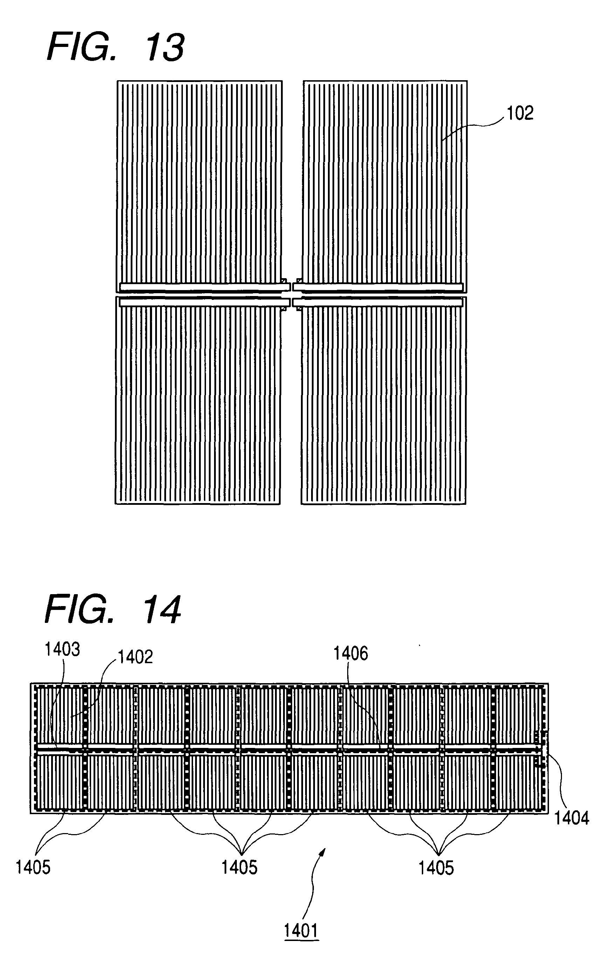

Moreover, two solar cell elements leading the light-receiving-surface terminal member 1201 out and additional two solar cell elements leading a light-receiving-surface terminal member on a side opposite to the two solar cell elements out are prepared to arrange the four solar cell elements at predetermined positional intervals so that each light-receiving-surface terminal member is brought to a position closest to the region surrounded by all solar cell elements as shown in FIG. 13.

Then, the power conversion unit 106 was fabricated by electrically connecting input terminals of the power converter 103 to solar cell elements respectively (FIG. 11).

In this case, two positive wires and two negative wires as the lead wires 107 of the power converter 103 are derived in the both directions from side faces of the power converter.

In this case, one cable having two cores formed of one positive wire and one negative wire may be used as the output lead wire 107.

### (Fabrication of solar cell module)

Then, a method for fabricating the solar cell module body 401 is described below by referring to FIG. 4.

First, five output lead wires of each power conversion unit 106 fabricated as described above are sequentially electrically connected each other.

By sequentially connecting the output lead wires as described above, power conversion units are connected in parallel.

Then, as shown in FIG. 4, a stacked structure is obtained by stacking on the back reinforcement 406, the filler 405, the power conversion units 106 electrically connected to each other, the filler 403 and the weather resistant film 402 in mentioned order.

It is possible to fabricate the solar cell module body 401 in which a plurality of power conversion units 106 are resin-sealed with the back reinforcement 406 and the weather resistant film 402 by using a vacuum laminator and melting the fillers 403 and 405 of the stacked structure at 150°C.

In this case, a hole for taking out an output lead wire is previously opened on the back reinforcement 406. Therefore, by cutting out the filler of this portion and connecting the output lead wire of a power conversion unit immediately below the inverter 105 to the inverter 105, it is possible to complete the solar cell module 101 shown in FIG. 1.

The present invention is described below in detail in accordance with the following Examples.

### (Example 1)

The solar cell module of this example is a solar cell module obtained by connecting five power conversion units each composed of four solar cell elements and one power converter, as shown in FIG. 1.

FIG. 1 is a schematic view showing a configuration example of a solar cell module of the present invention. As described above, numeral 101 denotes a solar cell module, 102 denotes a solar cell element, 103 denotes a DC-DC converter, 105 denotes an inverter and 106 denotes a power conversion unit.

In this case, the power conversion unit 106 is constituted by four solar cell elements and one DC-DC converter.

### (Solar cell element)

First, a solar cell element used for this example is described below in detail using FIG. 5.

In the solar cell element 102, a stainless steel substrate was used as a conductive substrate 501. Moreover, a photovoltaic layer 502 was formed on the stainless steel substrate. The photovoltaic layer 502 was obtained by forming a layer having a thickness of 500nm as a lower electrode layer by sputtering Al containing 1% of Si; and then by forming a p/i/n-type amorphous silicon semiconductor layer which had the n-type semiconductor layer thickness of 30nm formed by using PH₃, SiH₄ and H₂ gases for n-type semiconductor, the i-type semiconductor layer thickness of 400nm formed by using SiH₄ and H₂ gases for i-type semiconductor and the p-type semiconductor layer thickness of 10nm formed by using B₂H₆, SiH₄ and H₂ gases for p-type semiconductor in mentioned order in accordance with the plasma CVD method; and by forming an ITO having a film thickness of 80nm as an upper electrode layer in accordance with the sputtering method.

By applying the etching paste containing FeCl₃ and AlCl₃ onto the thus formed upper electrode in accordance with the screen printing method, heating the electrode and then cleaning the electrode, a part of the upper electrode was linearly removed.

Then, the polyimide-base-material using insulating double-side adhesive tape 503 was attached to one side of the conductive substrate thus electrically removed from the upper electrode on the light-receiving surface side, as an insulating double-side adhesive tape having a width of 7.5 mm {thickness: 200 µm (base material: 100 µm)}.

Moreover, a carbon wire obtained by previously coating a copper wire having a diameter of 100 µm with carbon paste is formed at a 5.6 mm pitch on the power generation region of the photovoltaic layer and the polyimide insulating double-side adhesive tape 503 as a collecting electrode 504.

Furthermore, a light-receiving-surface terminal member 505 was mounted on the polyimide insulating double-side adhesive tape 503 by using a silver-plated copper foil having a width of 5 mm, a length of 245 mm and a thickness of 100 µm and then thermally contact-bonded concurrently with the collecting electrode 504 under conditions of 200°C, 3 kg/cm² and 180 sec.

Furthermore, by coating the light-receiving surface with a fluororesin paint at a thickness of 100 µm in accordance with the spray coating method, the solar cell element 102 was completed.

The solar cell element completed in this example showed output characteristics of a maximum power voltage of 0.85 V and a maximum power current of 5 A.

### (DC-DC converter)

Then, a DC-DC converter which is one of components of this example is described below in detail.

In this case, FIG. 9 showing a schematic circuit diagram of a DC-DC converter connecting with a solar cell element is used for easy understanding.

In the case of a DC-DC converter 901 of this example, the output power of a solar cell element 902 is accumulated in a capacitor 904 through input terminals 903 of the DC-DC converter 901 and converted into AC power by alternately turning on/off MOSFETs 905 and 906.

Then, the AC power inputted to a switching transformer 907 is converted into AC power having a voltage corresponding to a predetermined transformation ratio (1:72 in the case of this example), rectified by a diode bridge 908 and passes through a filter capacitor 909. Thereafter, DC power is outputted to an adjacent DC-DC converter or inverter from the DC-DC converter 901 through an output lead wire.

Though not used for this example, it is also allowed to set a filter coil between the diode bridge 908 and the filter capacitor 909. It is also possible to omit both the filter capacitor and the filter coil depending on the system configuration.

Then, a control circuit 910 of the DC-DC converter 901 is described below. In the case of the control circuit 910 of this example, when the voltage of a solar cell element reaches the starting voltage of a control power-source generation IC, the voltage of the solar cell element is boosted to a desired control voltage by the control power-source generation IC in the control circuit.

Then, a reference waveform generation circuit is first operated by the control voltage, the reference rectangular waveform of a preset frequency is inputted to the waveform input section of a MOSFET driver, and gate drive signals S1 and S2 are inputted to the gate section of the MOSFET from the MOSFET driver to alternately turn on/off the MOSFET.

The output voltage of the DC-DC converter used in this case according to the above operation was about 200 V and the output current of it was about 80 mA under the optimum condition (25°C). Thus, the current was greatly decreased and the loss due to collection was greatly decreased.

### (Fabrication of power conversion unit)

The power conversion unit 106 was fabricated by arranging four solar cell elements 102 fabricated as described above at predetermined intervals in the same manner as in the case of the above example and then connecting all input terminals of the DC-DC converter 103 to output terminal members of the solar cell elements.

### (Fabrication of solar cell module)

Then, a method for fabricating a solar cell module using the above power conversion unit is described below by referring to FIG. 4.

As to materials used, ETFE (ethylene tetrafluoroethylene) was used for the weather resistant film 402, a steel plate coated with polyester resin and having a thickness of 0.4 mm was used for the back reinforcement 406, and EVA (ethylene-vinyl-acetate copolymer, weather resistant grade) was used for the fillers 403 and 405.

A stacked structure was obtained by stacking on the back reinforcement 406, the filler 405, five power conversion units 106 electrically connected to each other, the filler 403 and the weather resistant film 402 in mentioned order.

In this case, adjacent output lead wires of the five power conversion units 106 were previously connected each other.

Then, the solar cell module body 401 could fabricate in which the power conversion units 106 were resin-sealed with the back reinforcement 406 and the weather resistant film 402 by using a vacuum laminator and melting the fillers 403 and 405 of the stacked structure at 150°C.

In this case, a hole having a diameter of 15mm was previously opened at the portion for setting the inverter 105 of the back reinforcement 406, the fillers were removed after the solar cell module body 401 was fabricated, and the output lead wire of the endmost power conversion unit 106 was electrically connected to input terminals of the inverter 105.

The solar cell module 101 was fabricated in accordance with the above steps.

As described above, according to the solar cell module of this example, it is possible to electrically connect a plurality of solar cell elements in each power conversion unit to a DC-DC converter surrounded by all the solar cell elements and collect the output power of each solar cell element to the DC-DC converter at the minimum distance. Therefore, it is possible to reduce a wiring resistance and collect power at a less collecting loss.

Moreover, because outputs of the solar cell elements converted into the output power having a high voltage and very small current by the DC-DC converter, it is possible to reduce the influence of the resistance value of a wiring connected to an inverter and collect power to the inverter at a still less collecting loss.

Furthermore, in the case of this example, it is possible to input the input voltage of the control power-source IC at a comparatively high voltage such as about 3.4 V by connecting four solar cell elements in series in a power converter. Therefore, it is possible to reduce a loss due to control power-source generation.

### (Example 2)

As shown in FIG. 14, the solar cell module of this example is a solar cell module obtained by connecting ten power conversion units each composed of two solar cell elements and one power converter.

FIG. 14 is a schematic view showing a configuration example of a solar cell module of the present invention, in which numeral 1401 denotes a solar cell module, 1402 denotes a solar cell element, 1403 denotes a DC-DC converter as the power converter, 1404 denotes an inverter and 1405 denotes a power conversion unit.

### (Solar cell element)

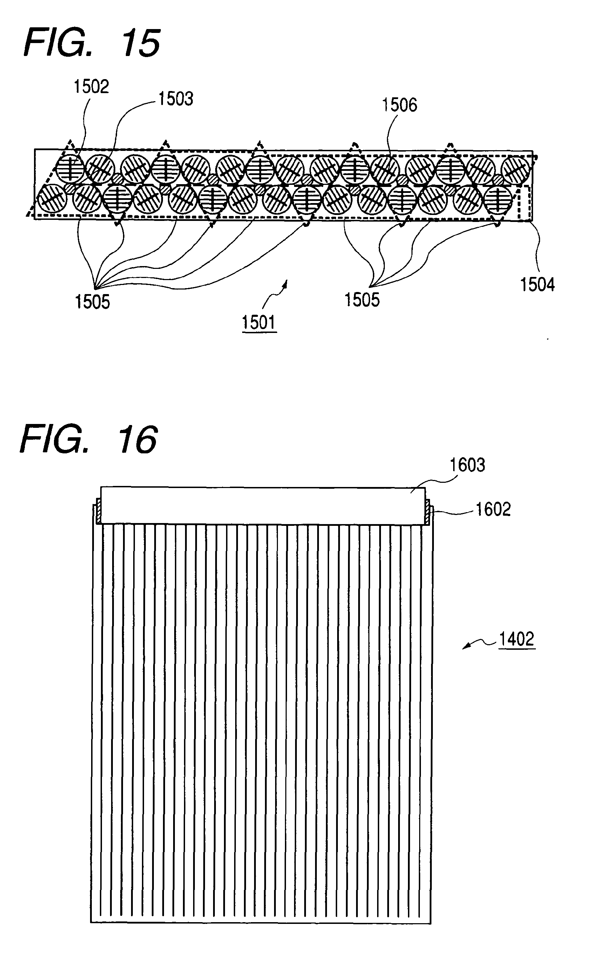

Because the solar cell element 1402 used for this example is the same as that of Example 1 in layer structure, material and the like, only different points are described. As shown in FIG. 16, the solar cell element 1402 of this example is different from Example 1 in that a polyimide-base-material using insulating double-side adhesive tape 1602 was used for one side of the conductive substrate on the light-receiving surface side as an insulating member having a width of 10 mm, and different in the direction of extending a copper foil having a width of 15 mm and a length of 220 mm and used as a light-receiving-surface terminal member 1603 from the element.

### (DC-DC converter)

Moreover, though DC-DC converter is almost the same as that of Example 1 in circuit configuration, it is different from Example 1 only in that the transformation ratio of the switching transformer is 1:144 which is almost two times the case of Example 1.

Then, the output voltage and output current of the DC-DC converter were about 200 V and about 35 mA respectively under the optimum operating condition (25°C) and the loss due to collecting current was greatly decreased.

### (Fabrication of power conversion unit)

Then, a method for fabricating the power conversion unit 1405 using the solar cell element 1402 formed in the above manner is described below.

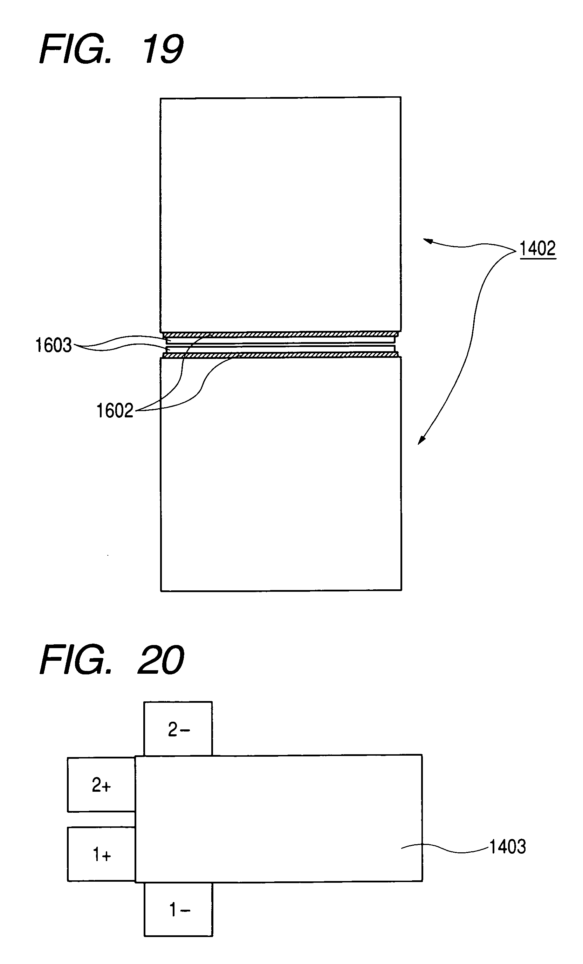

First, two solar cell elements 1402 were arranged at a predetermined positional interval as shown in FIG. 19. In this case, FIG. 19 is an illustration viewed from the non-light-receiving surface side of the solar cell element.

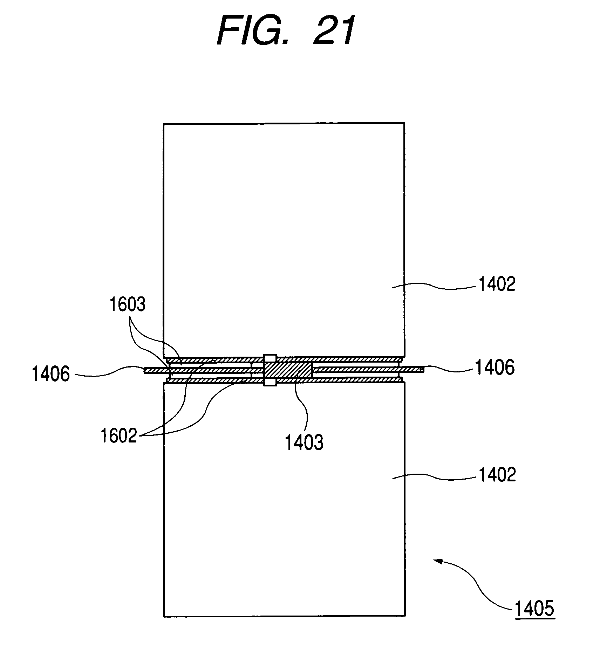

In this case, input terminals of the DC-DC converter 1403 were led out as shown in FIG. 20 and by soldering the corresponding terminals to the light-receiving surface of a solar cell element and a conductive substrate respectively, the power conversion unit 1405 shown in FIG. 21 was fabricated. That is, outputs of a plurality of solar cell elements 1402 constituting a power conversion unit are supplied to the power converter 1403 included in the power conversion unit.

### (Fabrication of solar cell module)

A method for fabricating the solar cell module of this example is almost the same as that of Example 1. A solar cell module body was fabricated by resin-sealing ten power conversion units whose output lead wires were connected to each other similarly as in Example 1, and an inverter was electrically connected to the power conversion unit at one end to complete the solar cell module of this example.

According to the solar cell module of this example, it is possible to collect power at a less collecting loss because a plurality of solar cell elements in each power conversion unit were electrically connected to a DC-DC converter surrounded by all the solar cell elements by short wiring members, and output power of each power conversion unit is collected to each DC-DC converter.

Moreover, because outputs of the solar cell elements are converted into the output power having a high voltage and a very-small current by the DC-DC converter, it is possible to reduce the resistance loss in a wiring 1406 extending from the DC-DC converter to the inverter and realize a less power loss.

### (Example 3)

In the case of this example, a solar cell module obtained by connecting ten power conversion units each composed of three solar cell elements and one power converter as shown in FIG. 15 is described.

FIG. 15 is a schematic view showing a configuration example of a solar cell module of the present invention, in which numeral 1501 denotes a solar cell module, 1502 denotes a solar cell element, 1503 denotes a DC-DC converter serving as a power converter, 1504 denotes an inverter and 1505 denotes a power conversion unit.

### (Solar cell element)

In the solar cell element 1502 used for this example, polycrystalline silicon as one example described for the embodiment of a photovoltaic device was used and its shape was almost circular. Solder plating was used for a collecting electrode and a solder-plated copper foil having a width of 5 mm and a thickness of 100 µm was used as a light-receiving-surface terminal member. Moreover, a terminal member was set to the non-light-receiving surface in the same manner as the case of the light-receiving surface.

### (DC-DC converter)

Moreover, though the circuit configuration of the DC-DC converter is almost the same as that of Example 1, Example 3 is different from Example 1 only in that the transformation ratio of a switching transformer is 1:100 in order to obtain the same output voltage optimum for the inverter.

The output voltage and the output current of the DC-DC converter used in this example under the optimum operating condition (25°C) of three solar cell elements were about 200 V and about 40 mA respectively. Therefore, the loss due to a collecting current was greatly decreased.

### (Fabrication of power conversion unit)

Then, a method for fabricating the power conversion unit 1505 using the solar cell elements 1502 formed in the above manner is described below.

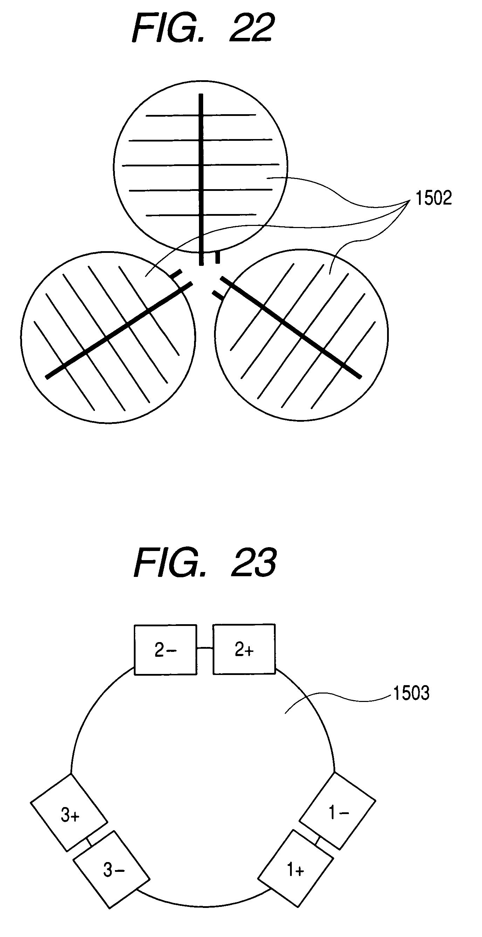

First, three solar cell elements 1502 were arranged at predetermined positional intervals as shown in FIG 22. In this case, FIG. 22 is an illustration viewed from the non-light-receiving surface side of the solar cell element.

In this case, input terminals of the DC-DC converter 1503 were led out as shown in FIG. 23, and by soldering the corresponding terminals to the light-receiving-surface member of a solar cell element and a conductive substrate respectively, the power conversion unit 1505 shown in FIG. 24 was fabricated. That is, outputs of the solar cell elements 1502 constituting a power conversion unit are supplied to the power converter 1503 included in the power conversion unit.

### (Fabrication of solar cell module)

A method for fabricating the solar cell module of this example is almost the same as the case of Example 1. That is, a solar cell module body is constituted by resin-sealing ten power conversion units in which output lead wires are connected to each other similarly as in Example 1, and electrically connected the inverter to the power conversion unit at one end, thereby fabricating the solar cell module of this example.

As described above, according to the solar cell module of this example, a plurality of solar cell elements in each power conversion unit are electrically connected to a DC-DC converter surrounded by all the solar cell elements with short wiring members and the output power of each power conversion unit is collected to each DC-DC converter. Therefore, it is possible to collect power at a less collecting loss.

Moreover, because outputs of the solar cell elements are converted into the output power having a high voltage and a very small current by the DC-DC converter, it is possible to reduce the resistance loss of a wiring 1506 extending from the DC-DC converter to the inverter and realize a less power loss.

### (Example 4)

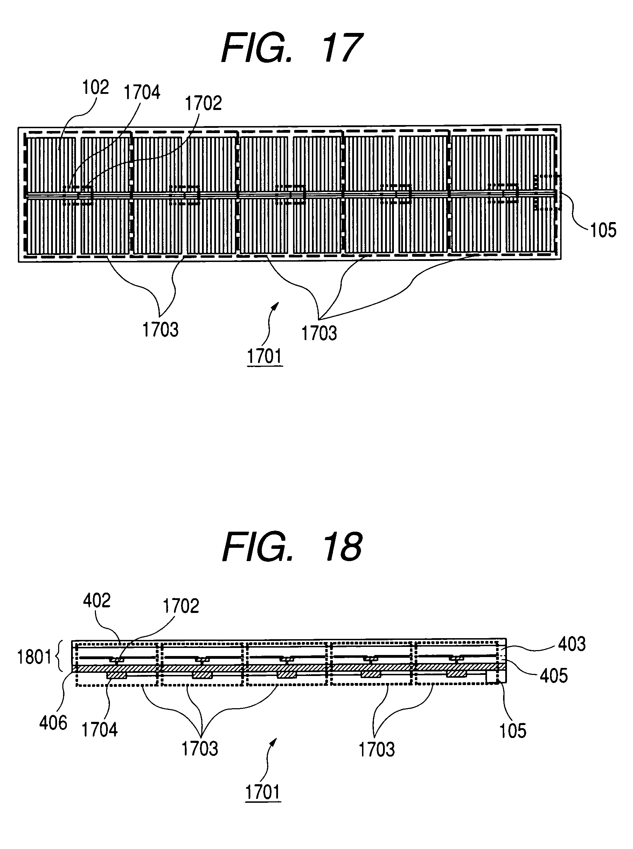

The solar cell module of this example is a solar cell module obtained by connecting five power conversion units each composed of four solar cell elements and one power converter as shown in FIGS. 17 and 18.

In the case of Example 1, a power conversion unit is constituted by previously electrically connecting four solar cell elements to one power converter. However, this example has a feature that a power converter is provided on the back reinforcement of a solar cell module.

FIGS. 17 and 18 are schematic diagrams showing a configuration example of a solar cell module of the present invention, in which numeral 1701 denotes a solar cell module, 102 denotes a solar cell element, 1702 denotes the input terminal substrate of a power converter, 1703 denotes a power conversion unit, 1704 denotes a power converter, 105 denotes an inverter and 406 denotes a back reinforcement.

### (Solar cell element)

Because the solar cell element 102 used for this example is the same as that used for Example 1, its description is omitted.

### (Series-connection member)

Then, because the input terminal substrate 1702 used for this example is almost the same as the input terminal printed circuit board in the DC-DC converter described for the above embodiment, its detailed description is omitted.

### (DC-DC converter)

Moreover, because the DC-DC converter 1704 serving as a power converter is also almost the same as the case of Example 1, only different points are described.

This example is different from the case of Example 1 only in that the DC-DC converter 1704 has only a pair of input terminals electrically connected to the input terminal substrate 1702, but other conditions including a circuit configuration are the same as the case of Example 1.

### (Fabrication of solar cell module)

First, a method for fabricating a solar cell module 1801 of this example is basically almost the same as the case of Example 1.

However, the solar cell module 1801 was fabricated by sealing four solar cell elements connected with the input terminal substrate 1702 at predetermined intervals without sealing a DC-DC converter inside.

In this case, a hole was previously opened on a back reinforcement at a portion located on the output terminal portion of the series connection member 1702 and after a solar cell module was fabricated, a filler was removed to form a plurality of power conversion units 1703 by electrically connecting the input terminal of a DC-DC converter to each input terminal substrate and adhering the DC-DC converter onto the back reinforcement. That is, outputs of a plurality of solar cell elements 102 constituting the power conversion units are supplied to the DC-DC converters 1704 included in the power conversion units.

Then, the solar cell module 1701 was fabricated by connecting output lead wires of adjacent DC-DC converters of each power conversion unit in parallel and electrically connecting the output terminal of a DC-DC converter at one end to the inverter 105.

According to the solar cell module of this example, a plurality of solar cell elements in each power conversion unit are electrically connected to a DC-DC converter surrounded by all the solar cell elements with short wiring members to collect the output power of each power conversion unit to each DC-DC converter. Therefore, it is possible to collect power at a less collecting loss.

Moreover, because outputs of the solar cell elements are converted into the output power having a high voltage and a very small current, it is possible to reduce the resistance loss of a wiring (not illustrated) extending from a DC-DC converter to an inverter and realize a less power loss.

In the case of this example, four solar cell elements were connected in series by using the input terminal substrate. However, it is also possible to connect four solar cell elements in parallel, or two solar cell elements in series and two solar cell elements in parallel depending on a configuration of substrate patterns.

### (Example 5)

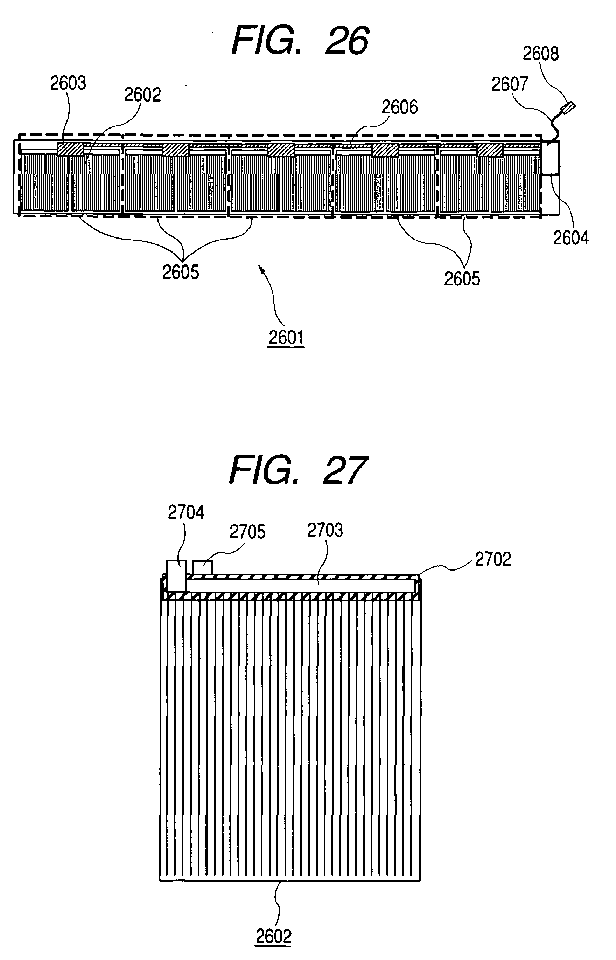

The solar cell module of this example is a solar cell module obtained by connecting five power conversion units each composed of two solar cell elements and one power converter as shown in FIG. 26.

FIG. 26 is a schematic view showing a configuration example of a solar cell module of the present invention, in which numeral 2601 denotes a solar cell module, 2602 denotes a solar cell element, 2603 denotes a DC-DC converter serving as a power converter, 2604 denotes an inverter and 2605 denotes a power conversion unit.

### (Solar cell element)

The solar cell element 2602 used for this example is the same as that Example 1 in layer structure, materials and the like, but different points in a terminal member and the like are described below. The solar cell element 2602 of this example was constituted by using a light-receiving-surface terminal member 2703 which was a copper foil having a width of 10 mm and a length of 245 mm as shown in FIG. 27 and connecting an extended terminal member 2704 having a width of 5 mm and a length of 20 mm to the member 2703 by soldering.

Moreover, a non-light-receiving-surface terminal member (not shown) was previously connected to a stainless steel substrate on a non-light receiving surface by laser welding and moreover, an extended terminal member 2705 having a width of 5 mm and a length of 20 mm was connected to the non-light-receiving-surface terminal member by soldering so that the member 2705 did not overlap with the extended terminal member 2704.

### (DC-DC converter)

Furthermore, though the circuit configuration in a DC-DC converter of Example 5 is almost the same as that of Example 1, Example 5 is different from Example 1 in that the transformation ratio of a switching transformer is 1:288 which is almost four times the case of Example 1 in order to obtain the same output voltage.

Furthermore, the DC-DC converter had four input terminals corresponding to extended terminal members of positive and negative electrodes of electrically-connected two solar cell elements respectively, and the two solar cell elements were connected in the DC-DC converter in parallel by an internal substrate pattern.

Then, the output voltage of the DC-DC converter used in this example case under the optimum operating condition (25°C) was about 200 V and the output current of it was about 70 mA and the loss due to a collecting current was greatly decreased.

### (Fabrication of solar cell module)

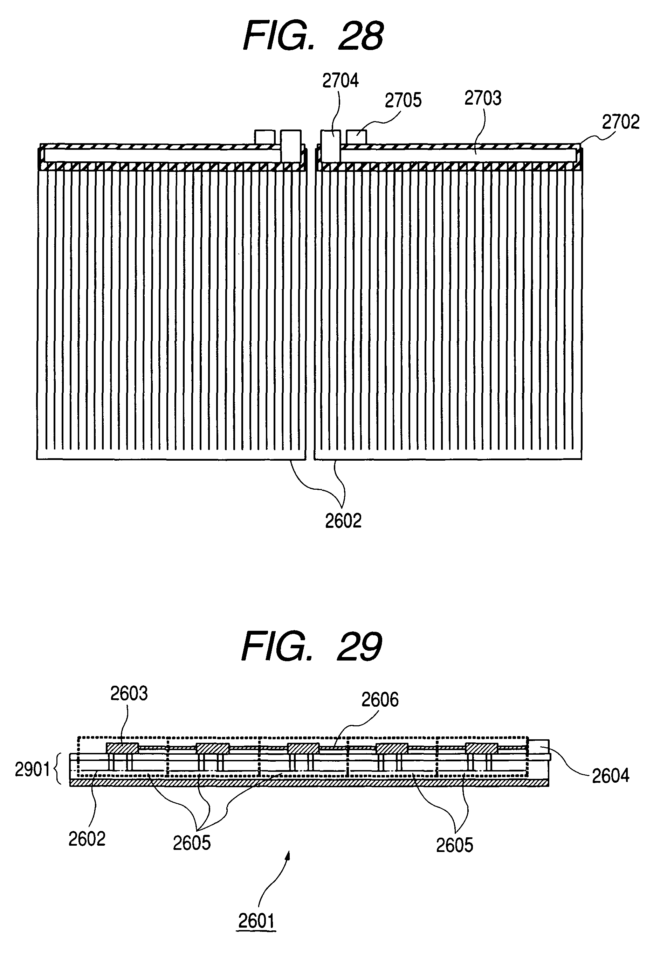

FIG. 29 shows a schematic sectional view of the solar cell module of this example.

A method for fabricating the solar cell module body 2901 of this example is the same as that of Example 1 except that the number and layout of solar cell elements used are different.

First, the solar cell module 2601 was fabricated by using two solar cell elements 2602 as one pair, arranging five pairs of the solar cell elements 2602, that is, the total of ten solar cell elements 2602 and resin-sealing them.

In this case, a plurality of power conversion units 2605 were formed by previously taking out the extended terminal members 2704 and 2705 from a slit portion formed on a weather resistant film so that they were not resin-sealed, setting the DC-DC converter 2603 on the extended members so as to cover them, connecting the input terminal of the DC-DC converter with each extended terminal member in the DC-DC converter and adhering the DC-DC converter onto the weather resistant film. That is, outputs of the solar cell elements 2602 constituting the power conversion units 2605 are inputted to DC-DC converters 2603 included in the power conversion units.

Then, the solar cell module 2601 was fabricated by connecting output lead wires 2606 of each DC-DC converter in parallel and electrically connecting the output terminal of a DC-DC converter at one end to the inverter 2604.

In this case, as shown in FIGS. 26 and 29, output lead wires are exposed to the surface of a solar cell module. However, it is also possible to use a structure in which the output lead wires are previously packed and sealed in the solar cell module body and connected to each other in a DC-DC converter.

In the case of the solar cell module of this example, each power converter 2603 is set at a position corresponding to a position adjacent to the gap between two adjacent solar cell elements 2602 constituting the power conversion units 2605. It can be also said that the positions of arranging the power converters 2603 are positions on the extension line of the gap between two adjacent solar cell elements 2602.

According to the solar cell module of this example, DC-DC converters in each power conversion unit are arranged at positions at which light-receiving-surface terminal members or non-light-receiving-surface terminal members of each solar cell element are the closest to each other so that the total collecting loss from two solar cell elements to DC-DC converters is minimized, the solar cell elements are connected with the DC-DC converters by short wiring members, and the output power of each solar cell element is collected to each DC-DC converter. Therefore, it is possible to further decrease the collecting loss.

Moreover, because outputs of the solar cell elements are converted into the output power having a high voltage and a very small current by the DC-DC converters, it is possible to reduce the resistance loss of the wiring 2606 from the DC-DC converters to the inverter and realize a less power loss.

In the case of the above examples, a DC-DC converter was used as a power converter of a power conversion unit. However, it is naturally allowed to use an inverter. In this case, the separately-set inverter of each of Examples 1 to 5 is unnecessary.

Moreover, the solar cell module having a plurality of power conversion units are described above. However, it is also allowed to constitute a solar cell module by only one power conversion unit and it is possible to constitute a photovoltaic power generation system by connecting two or more of the solar cell modules.

Furthermore, when power converters of a plurality of power conversion units are DC-DC converters, it is not necessary to set an inverter every solar cell module, and an inverter may be set at a position apart from a solar cell module. Moreover, two or more of the solar cell modules connected in series and/or in parallel may be connected to an inverter.

Also in this case, it is possible to further reduce a power transmission loss than a conventional case because the output current of a solar cell module is small compared with the case of a conventional system.

Moreover, in the case of the examples, a power conversion unit having a plurality of solar cell elements and a power converter, and a solar cell module having the power conversion unit are described. However, reduction of a collecting loss can be expected also by using a terminal box for collecting outputs of a plurality of solar cell elements instead of the power converter and realizing the same configuration. That is, reduction of a collecting loss can be expected also by a solar cell module including at least one power generation unit (basic block unit) constituted by a plurality of solar cell elements and one terminal box for collecting outputs of these solar cell elements.

A solar cell module (101) is provided with at least one power conversion unit (106) having a plurality of solar cell elements (102) and a power converter (103) provided in a position corresponding to a region surrounded by all the solar cell elements. Because the wiring distance from the output terminal of each solar cell element up to the input terminal of the power converter can be shortened, it is possible to reduce the loss of a wiring through which a low-voltage large current flows and provide an inexpensive solar cell module having a less collecting loss between the solar cell element and the power converter.

## Claims

1. A solar cell module comprising at least one power conversion unit having a plurality of solar cell elements and a power converter provided in a position corresponding to a region surrounded by all the solar cell elements.

2. The solar cell module according to claim 1, wherein at least two of the power conversion units are included and each power converter is electrically connected to a power converter of an adjacent power conversion unit.

3. The solar cell module according to claim 1, wherein outputs of the solar cell elements are inputted to the power converters corresponding to the solar cell elements, and the power converters convert the inputted outputs of the solar cell elements and output the converted outputs.

4. The solar cell module according to claim 1, wherein all output terminals of the solar cell elements are electrically connected to all input terminals of the power converters corresponding to the output terminals respectively.

5. The solar cell module according to claim 1, wherein a plurality of input terminals of the power converters are provided on the same and one surface.

6. The solar cell module according to claim 1, wherein a photovoltaic layer of each of the solar cell elements has pn junctions or pin junctions of two or more layers.

7. A solar cell module comprising at least one power conversion unit having a plurality of solar cell elements arranged on a plane and a power converter, wherein the power converter is arranged in a position of minimizing a sum of all collecting losses when collecting a power generated by the solar cell elements to the power converter.

8. A solar cell module comprising at least one power conversion unit having a plurality of solar cell elements arranged on a plane and a power converter, wherein the solar cell elements respectively have a terminal member and the power converter is arranged in the closest position between the terminal members in a state of arranging the solar cell elements.

9. A solar cell module comprising at least one power conversion unit having a plurality of solar cell elements arranged on a plane and a power converter, wherein the solar cell elements respectively have a terminal member and the power converter is arranged in the closest position between the terminal members in a state of arranging the solar cell elements and in a position of minimizing a sum of all collecting losses when collecting the power generated by the solar cell elements.

10. A solar cell module comprising at least one power conversion unit having two adjacent solar cell elements and a power converter provided in a position corresponding to a region on the extension of a gap between the two adjacent solar cell elements.

11. The solar cell module according to claim 10, wherein at least two of the power conversion units are included and each power converter is electrically connected to a power converter of an adjacent power conversion unit.

12. The solar cell module according to claim 10, wherein outputs of the two adjacent solar cell elements are inputted to the power converters corresponding to the outputs, and the power converters convert the inputted outputs of the two adjacent solar cell elements and output the converted outputs.

13. A solar cell module comprising at least one power generation unit having a plurality of solar cell elements and a terminal box provided in a position corresponding to a region surrounded by all the solar cell elements to collect outputs of the solar cell elements.

14. The solar cell module according to claim 13, wherein at least two of the power generation units are included and each power generation unit is electrically connected to a terminal box of an adjacent power generation unit.

15. A solar cell module comprising at least one power generation unit having two adjacent solar cell elements and a terminal box provided in a position corresponding to a region on extension of a gap between the two adjacent solar cell elements to collect outputs of the two adjacent solar cell elements.

16. The solar cell module according to claim 15, wherein at least two of the power generation unit are included and each power generation unit is electrically connected to a terminal box of an adjacent power generation unit.
